# EUROPEAN PATENT APPLICATION

(11) **EP 4 667 900 A1**
(43) Date of publication of application: **24.12.2025**
(21) Application number: 24182602.3
(22) Date of filing: 17.06.2024
(51) Int. Cl.: G01N 1/42, G01N 1/28

(54) **A DEVICE FOR PREPARING SAMPLES FOR USE IN A CRYO-ELECTRON MICROSCOPE**

(71) Applicant: FEI COMPANY, Hillsboro, Oregon 97124-5793 (US)
(72) Inventor: KUIJPER, Maarten, Eindhoven (NL); HAPERS, Bas, Eindhoven (NL); SPEE, Ivanka, Eindhoven (NL); VAN DER DOES, Marius, Eindhoven (NL); KOH, Adrian, Eindhoven (NL); HAZENBERG, John, Eindhoven (NL)
(74) Representative: Robinson, Louise Frances

(57) **Abstract**

A device for preparing samples for use in a Cryo-Electron Microscope. The device comprises a holder for holding a sample carrier, at least one jetting device that is arranged for providing a jet of cryogenic fluid to said sample carrier, and a transfer mechanism that is operably coupled to the holder for bringing the holder to a jetting position. In the jetting position the holder is located near the at least one jetting device for receiving said jet of cryogenic fluid. The device further comprises a plunging reservoir for receiving a volume of cryogenic fluid, wherein the transfer mechanism is additionally arranged for bringing the holder to a plunging position. In the plunging position the holder is positioned at least partly inside an internal volume of said plunging reservoir for bringing the sample carrier in contact with cryogenic fluid.

## Description

The disclosure relates to a device for preparing samples for use in a cryo-electron microscope, comprising a holder for holding a sample carrier and at least one jetting device that is arranged for providing a jet of cryogenic fluid to said sample carrier.

Such a device is known from US9865428B2 in name of applicant.

The known device comprises a pair of conduits for transporting cryogenic fluid, each of which conduits opens out into a mouthpiece, which mouthpieces are arranged to face each other across an intervening gap in which the sample can be arranged. The known device further comprises a pumping mechanism, for pumping cryogenic fluid through said conduits so as to concurrently flush from said mouthpieces and suddenly immerse the sample in cryogenic fluid from two opposite sides. The conduits of the known device are arranged in a plunger, whereby each conduit has an entrance aperture on an underside of the plunger, and said gap is provided as a slot in a topside of the plunger. By moving the plunger into a bath of liquid ethane, the cryogenic fluid is forced through said conduits, so that the sample is jetted with cryogenic fluid from opposite sides.

The known device is able to provide excellent results for various samples. However, the known device can still be improved so that a wider range of samples can be prepared.

To this end, the disclosure provides a method as defined in claim 1.

The device as described herein is arranged for preparing samples for use in a Cryo-Electron Microscope. The device comprises a holder for holding a sample carrier. The sample carrier can be a cryo-EM grid, for example. The device comprises at least one jetting device that is arranged for providing a jet of cryogenic fluid to said sample carrier. The jetting device allows a jet or stream of cryogenic fluid to be brought into contact with the specimen provided onto the sample carrier so that the specimen may be vitrified. The device comprises a transfer mechanism that is operably coupled to the holder. The transfer mechanism is arranged for bringing the holder to a jetting position. In the jetting position of the holder, the holder is located near the at least one jetting device, so that the sample carrier held by the holder is able to receive said jet of cryogenic fluid. The device as described herein may comprise a control unit for controlling operations of the device, which can include controlling the movement of the transfer mechanism and controlling the settings of the jetting device, which will be discussed in more detail later.

The device as defined herein further comprises a plunging reservoir for receiving a volume of cryogenic fluid, such as, for example, liquid ethane. As defined herein, the transfer mechanism is additionally arranged for bringing the holder to a plunging position. The transfer mechanism may be arranged to function as a plunging device. The transfer mechanism may be arranged for moving the holder from an idle position to a plunging position. In the idle position, the holder is located at a distance from said plunging reservoir. This ensures that the sample is at distance from the liquid ethane, so that it cannot be cooled. In the plunging position the sample carrier is inside said internal volume of said plunging reservoir. The transfer mechanism may be arranged to function as the plunging device, by moving the sample carrier to the plunging position at an appropriate speed so that plunge freezing of the sample occurs.

Thus, the device as described herein comprises a jetting mode and a plunging mode, with a single transfer mechanism for bringing the sample carrier to the jetting mode and/or the plunging mode. Thus, the device as disclosed herein allows samples to be vitrified by using a jet of cryogenic fluid and/or using a plunging method, which allows more flexibility in the samples being prepared by said device. Also, the use of one transfer mechanism that is able to bring the sample carrier to either the jetting position or the plunging position provides for a compact and efficient design. With this, the object as defined herein is achieved.

Advantageous embodiments will be described below.

As discussed, the device comprises a plunging mode and a jetting mode. In the plunging mode the control unit may be arranged for controlling said transfer mechanism to move said holder to said plunging position. In the jetting mode the control unit may be arranged for controlling said transfer mechanism to move said holder to the jetting position. Using the control device for allowing the jetting mode and/or plunging mode allows for reliable operation of the device.

In an embodiment, the device is arranged so that the plunging mode and the jetting mode are at least mutually exclusive. This means that the user can select either a jetting mode, or a plunging mode. When the jetting mode is chosen, the sample is jetted only. When the plunging mode is chosen, the sample is plunge frozen only.

In an embodiment, the device is arranged for allowing a combination of jet freezing and plunge freezing. Here, the sample can be jetted first, after which the sample is plunge frozen.

In an embodiment, the plunging reservoir comprises a cryogen inlet and a cryogen outlet. The cryogen inlet can be used for supplying cryogenic fluid to the reservoir. The cryogen outlet can be used to drain cryogenic fluid from the reservoir. The device may comprise a cryogenic fluid supply unit, which may comprise a cryogenic fluid storage. The control unit may be arranged for supplying cryogenic fluid from said cryogenic supply unit to said cryogen inlet for filling the plunging reservoir with cryogenic fluid in said plunging mode. In the jetting mode, the control unit can be arranged for removing cryogenic fluid from said plunging reservoir through said cryogen outlet.

In an embodiment, the control unit is arranged for supplying cryogenic fluid from said cryogenic supply unit to said cryogen inlet for filling the plunging reservoir with cryogenic fluid in said jetting mode, in particular once initial jetting of the sample carrier is substantially complete. This means that the jetting may be started first, after which the plunging reservoir can be filled. The sample carrier may be submerged into cryogenic fluid after the initial jetting has completed. Whilst submerged, the jetting may still continue to provide a fresh supply of cold cryogenic fluid.

In an embodiment, the device comprises a piston that is fluidly connected to said cryogenic supply unit, said piston having an internal volume that defines said plunging reservoir for holding said cryogenic fluid, wherein said piston comprises a sample carrier bore that opens into said inner volume defining said plunging reservoir, and wherein said piston comprises at least one jetting bore that opens into said inner volume defining said plunging reservoir, wherein said jetting bore is fluidly connected to said cryogenic supply unit so that a cryogenic jet can be formed out of said at least one jetting bore.

In an embodiment, the piston is movably provided within said cryogenic supply unit, wherein said piston is movable from a top position to a bottom position, wherein in said plunging mode the piston is moved to said bottom position so that said plunging reservoir is filled with cryogenic fluid, and wherein in said jetting mode the piston is moved to said top position so that said plunging reservoir is substantially free from cryogenic fluid.

In an embodiment, said piston is movable, in the jetting position, from said top position to said bottom position whilst said jetting bore is providing said jet of cryogenic fluid to said sample carrier, so that the plunging reservoir is filled with cryogenic fluid during said jetting.

In an embodiment, said holder is arranged for moving said piston from said top position to said bottom position in said jetting mode.

In an embodiment, the the holder comprises a tweezer.

In an embodiment, the device comprises a user input device that is arranged for a user to select the plunging mode or the jetting mode.

The user input device may be arranged for a user to select the plunging mode and the jetting mode mutually exclusively.

The control unit may be connected to said user input device and can be arranged for operating the device to perform the plunging mode or the jetting mode based on the input provided by the user input device.

The device may further comprise one or more of:
- an applicator for applying a liquid containing a specimen to a sample carrier provided in said sample holder;
- a device for removing excess liquid from a sample carrier provided in said sample holder.

The device as disclosed herein will now be elucidated in more detail on the basis of exemplary embodiments and the accompanying schematic drawings, in which:
Figures 1A-1B illustrate (a particular embodiment of) a common sample structure used in vitrification procedures;
Figure 2 shows sample damage that can result from application of a prior-art vitrification procedure;
Figures 3 shows a schematic view of a jetting device;
Figures 4A-4B render a longitudinal cross-sectional view of aspects of a first embodiment of a device according to the present disclosure;
Figures 5A-5E render a longitudinal cross-sectional view of aspects of a second embodiment of an device according to the present disclosure;
Figure 6 shows a detailed embodiment of a device according to the present disclosure;

In the Figures, where pertinent, corresponding parts may be indicated using corresponding reference symbols. It should be noted that, in general, the Figures are not to scale.

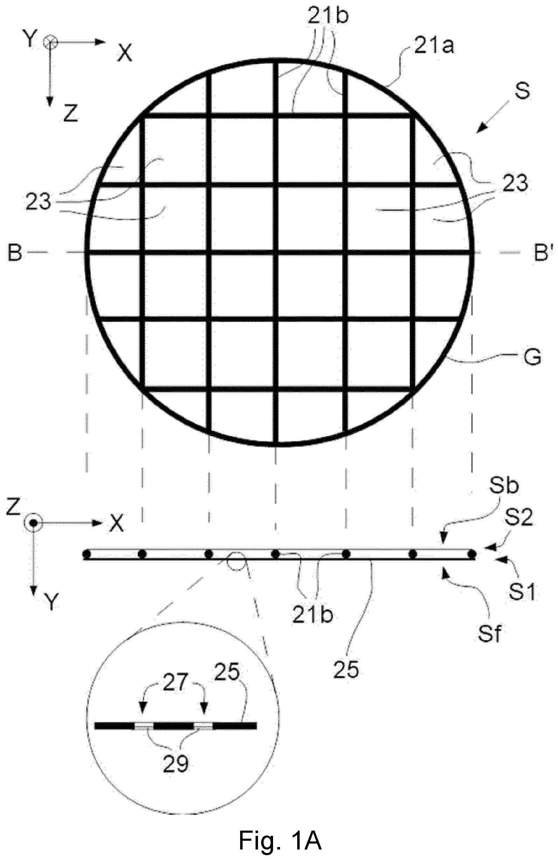

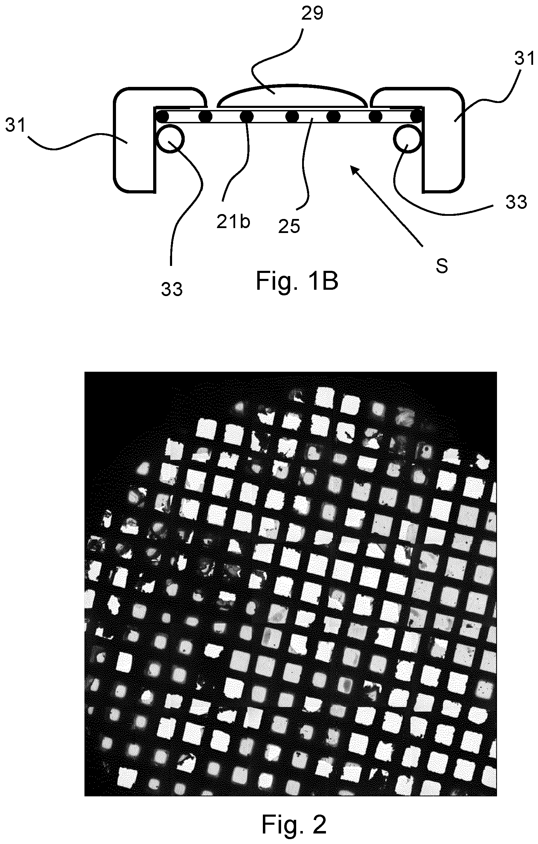

Fig. 1A and 1B render detailed (magnified) views of aspects of a particular embodiment of a sample S that can be used in conjunction with the present invention. This particular type of sample S comprises what is often referred to as a "grid" G. It comprises a circular ring 21a of wire (e.g. comprising Cu or Ni, for instance), the diameter of the ring typically being of the order of about 3 mm and the diameter of the wire typically being of the order of about 20-100 µm. Attached within the ring 21a are straight wire portions 21b, which are (in this case) arranged to form an orthogonal grid pattern, thus defining a matrix-like array of apertures (openings/holes/windows) 23. The middle portion of Fig. 1A shows a transverse cross-sectional view of the upper portion of the Fig., taken along the diameter B-B'. It shows that the grid G has a substantially planar (plate-like) form, with opposed first (S1) and second (S2) "faces" substantially parallel to one another. As here depicted, a membrane 25 has been spanned upon the first face S1 (and, optionally, affixed to the wires 21b, e.g. using an adhesive or by molten bonding). This membrane 25 may, for example, comprise a carbonaceous material such as nylon or graphene, and will typically have a thickness (in the Y direction) ranging from about 0.3 nm to hundreds of nm. The membrane 25 contains a distribution of perforations 27, which are clearly visible in the detailed view at the bottom of the Fig. 1A. These perforations 27 typically have a diameter (parallel to the XZ plane) in a range of ca. 1.2 - 3.5 µm (e.g. ~ 2 µm). In essence, the grid G acts as a scaffold for the membrane 25, and the membrane 25 in turn acts as a supporting structure for the perforations 27 (so that it is sometimes referred to as a "holey carbon support"). It is within the perforations 27 that the ultimate "sample" or "specimen" is to be provided and supported - in the form of a thin film 29 of aqueous liquid (comprising one or more study specimens suspended therein) that is spanned across each given perforation 27, remaining in place (inter alia) by virtue of surface tension effects. It should be noted that structures as depicted in Fig. 1A (grid G + perforated membrane 25, 27) and as described above are commercially available, e.g. from firms such as Ted Pella, Inc., of Redding, California, USA. It is also possible to purchase (a variety of) pre-manufactured holey carbon films (corresponding to the perforated membrane 25, 27), e.g. from firms such as Quantifoil Micro Tools GmbH, Jena, Germany. Inter alia in the context of the present invention, the illustrated structure can be regarded as having a "backside" Sb and a "frontside" Sf.

A film 29 of aqueous liquid can be provided in the various perforations 27 of the membrane 25 using methods well described in technical literature and known to the skilled artisan. In one such known method, a sheet of blotting paper (not depicted) is pressed against the outer/lower surface of membrane 25, is then moistened with the aqueous liquid in question, and is subsequently removed (e.g. peeled off) of the membrane 25 - causing (most of) the apertures 27 to be endowed with a (mini-)film 29 of the aqueous liquid, which is spanned within them by surface tension effects. A method of this type is described, for example, in the article Electron Microscopy of frozen water and aqueous solutions by J. Dubochet et al. in Journal of Microscopy, vol. 128, pt 3, December 1982, pp. 219-237, , and will not receive further attention here. Reference is also made to an alternative method that is set forth in US 9,772,265 (incorporated herein by reference).

Now turning to Fig. 1B, an example of an EM-grid sample S with a mechanical contour 31 for improved handling is schematically shown. Here, the grid S as described in Fig. 1A is enclosed in a first contour body 31 that is substantially circular and has an L-shaped cross-sectional area. This first contour body 31 is also referred to as clip ring 31, and is known to those skilled in the art. The grid S is provided within a recess of said mechanical contour 31, abutting a recess surface of said mechanical contour 31. A fixating element 33, in the form of a c-shaped clip 33 (also referred to as c-clip 33) holds the grid S firmly in place in the recess of the mechanical contour 31. A thin film 29 of acqueous liquid, comprising the sample/specimen to be studied, is provided on the backside or frontside of the grid S (here shown in an exaggerated way, drawing is not to scale).

Turning now to Fig. 2, this shows a particular sample of a type such as that illustrated in Fig. 1A and 1B, after vitrification using the method set forth in the aforementioned US 2017/0169991 A1 (same flush applied to backside and frontside of sample). The light gray squares/cells are undamaged with successful vitrification procedure, whereas the white squares/cells are damaged where membrane breakage/de-lamination has occurred (to a greater or lesser extent). The dark/mottled squares/cells correspond to locations where vitrification happened but with too thick ice (to a greater or lesser extent). In the current situation, it is seen that of the order of ca. 25% of the squares/cells are sub-optimal. As set forth above, closer examination of the sample (not evident in the current Fig.) reveals that the damaged squares/cells have been detached with a prevalent backside-to-frontside directionality.

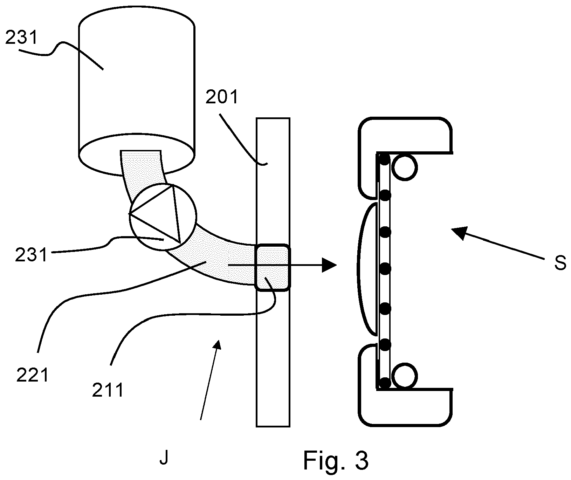

Fig. 3 shows an embodiment of a jetting device J that can be used for preparing cryo EM samples using a jetting technology. Here, a sample S is provided in front of a nozzle 201, having nozzle opening 211, and wherein (schematically) a reservoir 231 of cryogenic fluid is connected to the nozzle 201 by means of a conduit 221. A pump 231 is provided to pump liquid from the reservoir 231 to the nozzle 211, and onto the sample S. By pumping cryogenic fluid from the reservoir it is possible to vitrify the sample.

This jetting device J can be used in embodiments of the device as described herein.

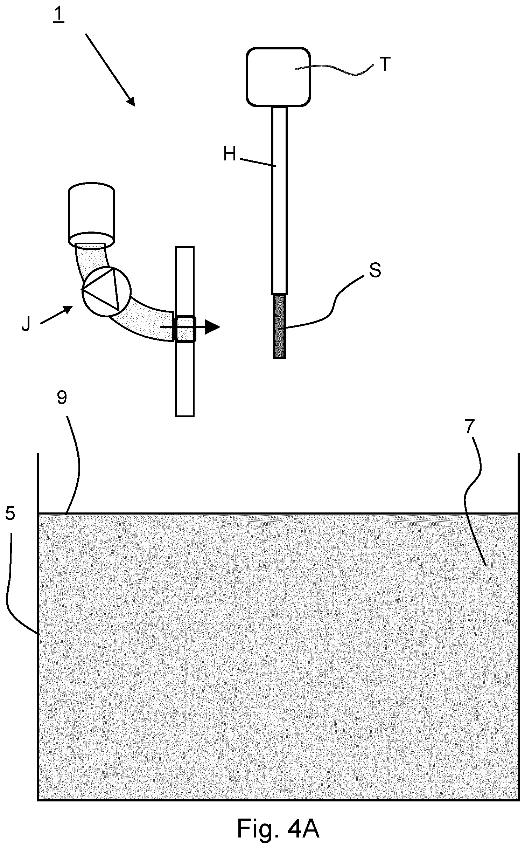

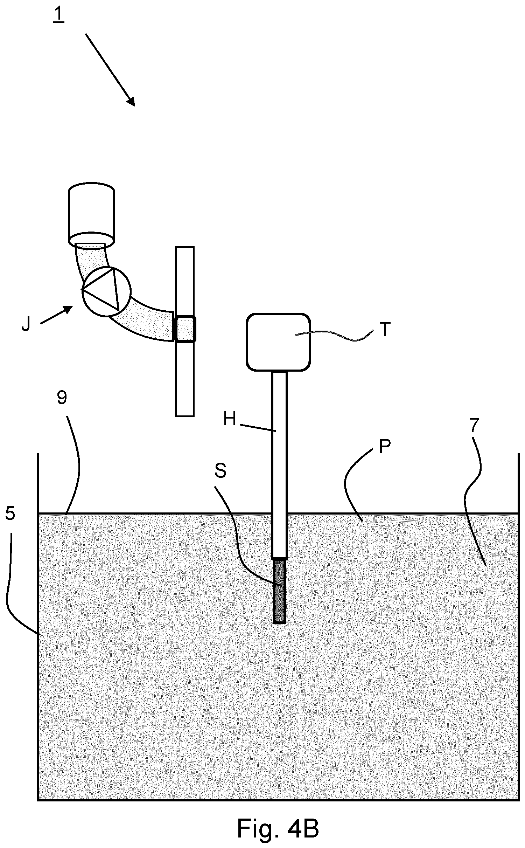

A first example is given in Fig. 4A and 4B, which show a first embodiment of the device as described herein. The device 1 comprises 1 a holder H for holding a sample carrier S, at least one jetting device J that is arranged for providing a jet of cryogenic fluid to said sample carrier, and a transfer mechanism T that is operably coupled to the holder H for bringing the holder to a jetting position. Fig. 4A indicates the jetting position, wherein the holder H is located near the jetting device J for receiving a jet of cryogenic fluid. Here, the jetting device J is embodied as discussed previously with respect to Fig. 3.

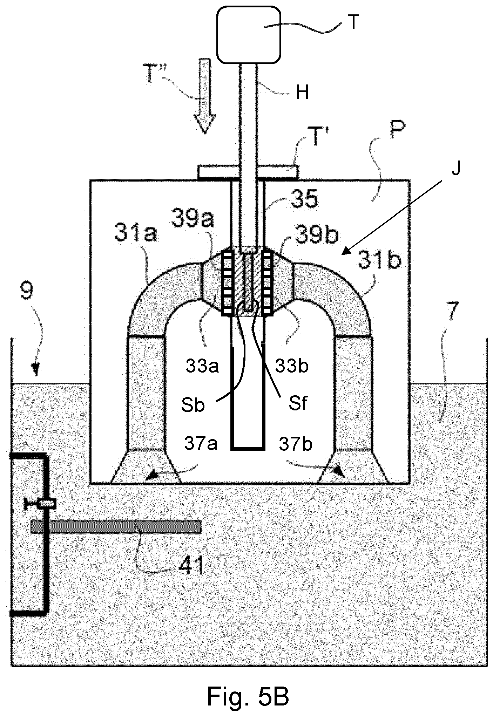

As can be seen in Fig. 4A and 4B, the device 1 according to this embodiment additionally comprises a plunging reservoir 5 for receiving a volume of cryogenic fluid 7. Fig. 5B shows that the transfer mechanism T is additionally arranged for bringing the holder H to a plunging position, wherein in the plunging position the holder H is positioned at least partly inside an internal volume of said plunging reservoir 5 for bringing the sample carrier in contact with cryogenic fluid.

Thus, Fig. 4A and 4B disclose a relatively simple embodiment of a device 1 as described herein, having a jetting mode and a plunging mode, and having a transfer mechanism for bringing the sample carrier S to the desired jetting or plunging position.

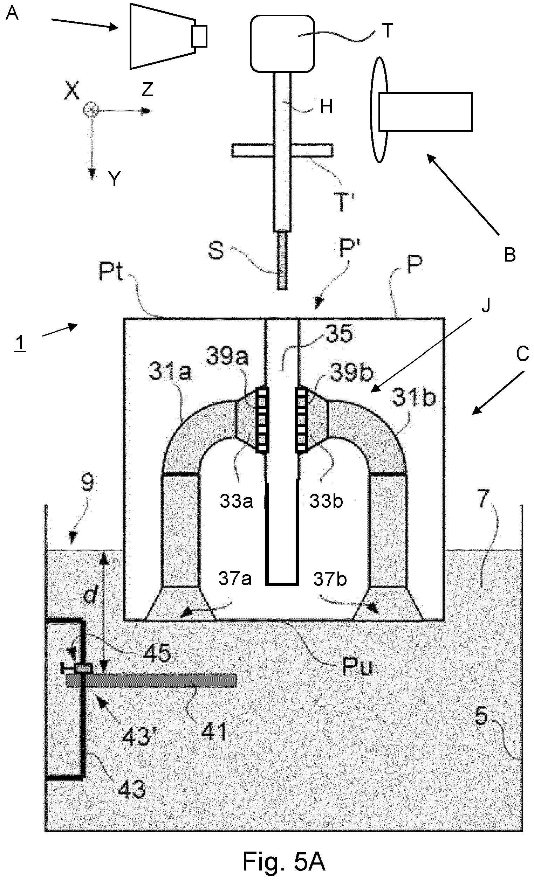

Fig. 5A-5E show aspects of another embodiment of a device as described herein. Starting with Fig. 5A, this shows a device 1 for preparing samples for use in a Cryo-Electron Microscope. The device comprises a holder H for holding a sample carrier S. The device also comprises at least one jetting device J that is arranged for providing a jet of cryogenic fluid to said sample carrier S.

Also provided are specimen applicator device A, which is arranged for applying a specimen to the sample carrier S, and a device B for removing excess liquid from sample carrier S. The transfer mechanism T may be arranged for moving the sample carrier S in appropriate positions for applying the sample at the applicator device A and for blotting excess liquid at the device for removing excess liquid B. The device for removing excess liquid B may be a blotting device B, which uses a piece of blotting paper to remove the excess liquid. These blotting devices are known to those skilled in the art. Other devices and techniques for removing excess liquid may be used as well, such as blowing, sucking, wiping, shaking and/or drying.

It is noted that in the embodiment shown, the applicator device A and the device B for removing excess liquid are present. However, these devices A and B are optional. It is conceivable that both devices are left out. It is also conceivable that only the applicator device A is present. Alternatively, it is conceivable that only the device B for removing excess liquid is present.

As shown in Fig. 5A, the jetting device J according to this embodiment comprises a pair of conduits 31a, 31b for transporting cryogenic fluid. These conduits open into mouthpieces 33a, 33b that face each other across an intervening gap 35. The mouthpieces 33a, 33b are provided with nozzle plates 39a, 39b. Nozzle plate 39a may be provided with a nozzle opening. Nozzle plate 39b may also be provided with a nozzle opening. Alternatively, the nozzle plates may be left out completely. It should be noted that in the embodiment shown, there are two nozzles, which are positioned in such a way as to face each other. An embodiment in which only a single nozzle is present is conceivable as well.

It should be noted that:
- For convenience, the various components 31a, 31b, 33a, 33b, 35, 37a, 37b are here depicted as residing in a body P, which may serve as a matrix/structure to keep them in place; for example, body P might be a plug/block of metal, ceramic or epoxy in which these various components have been created by casting, molding, machining or 3D-printing, for instance. However, this does not necessarily have to be the case, and the various components could instead be (quasi) free-standing structures.
- The orifices 37a, 37b; 33a, 33b are here depicted as being flared, but that does not necessarily have to be the case.
- The gap 35 is depicted as being of uniform width, but it could alternatively be tapered, for example. It should ideally be relatively narrow (in the Y direction), so as improve initial flush synchronization and symmetry.

Also depicted in Fig. 5A is a holder H (such as a tweezers, pincers, pliers, clamp, robot arm, etc.) that can be used to grasp and manipulate a sample carrier S, e.g. by gripping it along its edge, such as the mechanical contour 31 shown in Fig. 1B. This holder H is attached to transfer mechanism T. The transfer mechanism T can be used to transfer the sample carrier S throughout the device 1. For example, the transfer mechanism T may be used for transferring the holder H from the application device A, past the excess liquid removal device B, after which sample carrier S can be positioned in the gap 35 and between the mouthpieces 33a, 33b of the jetting device J.

Thus, the transfer mechanism T is operably coupled to the holder H for bringing the holder H to a jetting position, wherein in the jetting position the holder is located near the at least one jetting device J for receiving said jet of cryogenic fluid.

As already set forth above, one way to supply cryogenic fluid to the entrance orifices 37a, 37b is to simply connect them to (an electrical) cryogen pump (and associated cryogen reservoir) using suitable tubing/piping; one can then pump cryogen through the conduits 31a, 31b and out of the mouthpieces 33a, 33b so as to flush/shower (a sample S located in) the gap 35 with cryogenic fluid. Such an embodiment is similar to the embodiment that is described under reference to Fig. 3.

However, in the embodiment shown in Fig. 5A-5E, use is instead made of a (manual) piston action to move cryogenic fluid through the conduits 31a, 31b. To this end, the body P is embodied as a plunger, which has an underside Pu (in which the entrance orifices 37a, 37b are located) and a topside Pt (through which it is possible to access gap 35). This plunger P can then, for example, be (partially) plunged/dipped into a reservoir 5 of cryogen 7; as the plunger's underside Pu moves beneath the surface 9, cryogen 7 will be (progressively) forced through the entrance orifices 37a, 37b, though the conduits 31a, 31b and out of the nozzles 39a, 39b (see the progression from Fig. 3A to 3B to 3C, which illustrate part of this motion). Note in Fig. 5A that, prior to insertion of tool T / initiation of the plunging procedure, the conduits 31a, 31b have been primed/pre-filled with cryogen 7, e.g. as a result of pre-syphoning and/or capillary action from a previous plunging iteration. In this way, one ensures that a supply of cryogen is waiting in close proximity to the inserted position of the sample S, ready to gush out almost instantaneously, and thus lowering the risk of an unsynchronized flush/flow from both sides of the sample S.

To produce the desired motion for enabling jetting of the sample S, the depicted set-up uses the holder H to apply downward force to the plunger P - although this does not necessarily have to be the case, and one could instead push the plunger P downward by other means. As shown in Figs. 3B and 3C, the holder H has a protrusion/lug T' that engages with a reciprocal area/part P' of the topside Pt of plunger P, allowing downward force on holder H to transfer downward momentum to plunger P: see the illustrative downward arrow T" in Figs. 3B, 3C. Moreover, the protrusion T' can (if so desired) be exploited to ensure that the sample S is inserted to an optimal depth in gap 35 (ideally substantially symmetrically between mouthpieces 33a, 33b) and can also be used to provide correct lateral positioning of the sample S in the gap 35 (once again, ideally with the (vitreous film of the) sample equidistant from mouthpieces 33a, 33b).

In a non-limiting example of a set-up such as that depicted here, the following illustrative (and approximate) values may apply:
- Sample S comprises a planar grid of diameter 3 mm and thickness 0.4 mm.
- Diameter of mouthpieces 33a, 33b: 3-4 mm.
- Diameter of conduits 31a, 31b: 2.5 mm.
- Separation of mouthpieces 31a, 31b / width of gap 35: 1 mm.
- Flow rate from mouthpieces 31a, 31b: ~5-15 m/s.

The skilled artisan will be able to tailor his own values to the requirements of a given situation.

In the embodiment shown in Fig. 5A-5E, the depicted device 1 has been configured such that the flush of cryogenic fluid applied from (left) mouthpiece 33a is different to that applied from (right) mouthpiece 33b - more specifically, to cause the flush from mouthpiece 33a to be of shorter duration than that from mouthpiece 33b. To this end, use is made of a shuttering mechanism (41, 43, 45) to close off (left) conduit 31a (which is connected to said (left) mouthpiece 33a) after elapse of a given time interval. More specifically, this shuttering mechanism comprises:
- A lid (cover/blanker) 41, disposed at a selected nominal distance d below the surface 9 of the cryogen bath.
- A rail/guide 43, which permits and guides motion of the lid 41 substantially parallel to the Z axis. To this end, the lid 43 may comprise an aperture 43' (or other suitable structure, such as a clasp or runner, for example) that cooperates with rail 43 so as to allow relative motion of the two.
- An adjustable stop (such as a screw-locked sliding collar, for instance) that prevents upward motion of lid 41 beyond a certain point (at depth d).

As set forth above, the lid 41 may be naturally buoyant in cryogen 7 (e.g. because it is hollow) and/or may be biased upward using a spring, piston or magnetic arrangement, for example. In this way, lid 41 can co-move downward when it is engaged by plunger P, but will return/relax back upward when plunger P is disengaged therefrom. With particular reference to the individual Figures:
- In Fig. 5B, such engagement has not yet occurred. The plunger P is moving downward through cryogen 7, forcefully introducing (more) cryogen into the conduits 31a, 31b. The associated pressure head causes cryogen to flush from both mouthpieces 31a, 31b, as illustrated in Fig. 3A by the hatched area filling the space between the mouthpieces 31a, 31b.

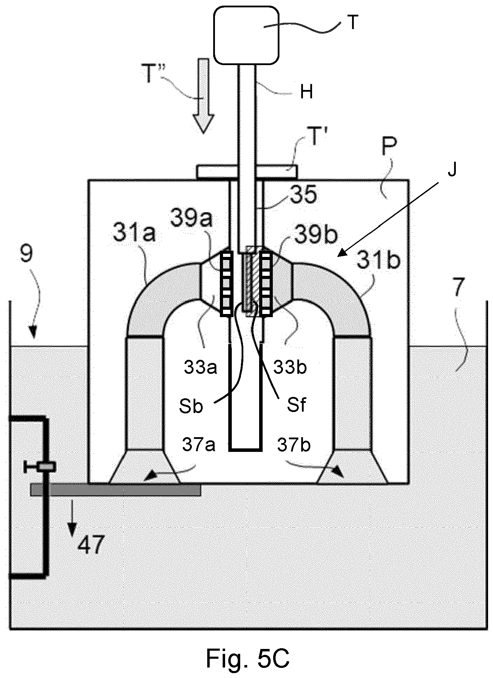

- In Fig. 5C, the plunger P has engaged with lid 41, and the plunger P and lid 41 are co-moving downward (see arrow 47). Because of its size/positioning, the lid 41 only engages with left entrance orifice 37a, blocking/capping it and preventing flow of cryogen into it; on the other hand, right entrance orifice 37b is not impeded in this way. Consequently, the flush of cryogen from left mouthpiece 33a ceases, whereas the flush from right mouthpiece 33b continues. Note that the hatched area (flush) is now only coming from right mouthpiece 33b.

As set forth above, the skilled artisan can choose d and/or the downward velocity of plunger P so as to cause this termination of the flush from left mouthpiece 33a at a pre-selected time interval after commencement of flushing. This time interval may, for example, be of the order of 10-200 milliseconds.

It is noted that the use of the shuttering mechanism 41 as depicted in Fig. 5A-5C is entirely optional. Equal flush on both sides of the sample S is conceivable as well.

Fig. 5A-5C have shown a first mode of the device as disclosed herein. This first mode is a jetting mode, wherein a jet of cryogenic fluid is applied to the sample in order to vitrify the sample.

The device as disclosed herein has, however, also a second mode. This second mode is a plunging mode, which allows the sample carrier S to be plunged into a reservoir of cryogenic fluid. This plunging reservoir is, in an embodiment, provided below the jetting device. In the embodiment shown in Fig. 5a-5C, the intervening gap 35 extends more downwards into an internal reservoir 36, which functions as the plunging reservoir for this device. This internal reservoir 36 is situated below the mouthpieces of the body P.

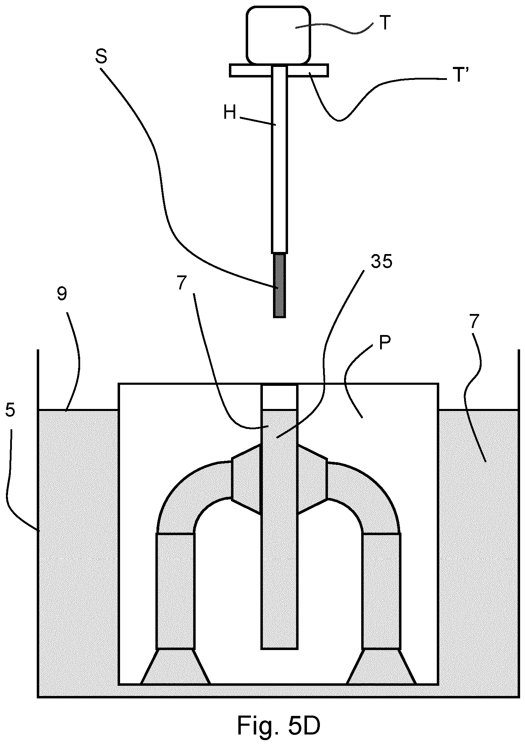

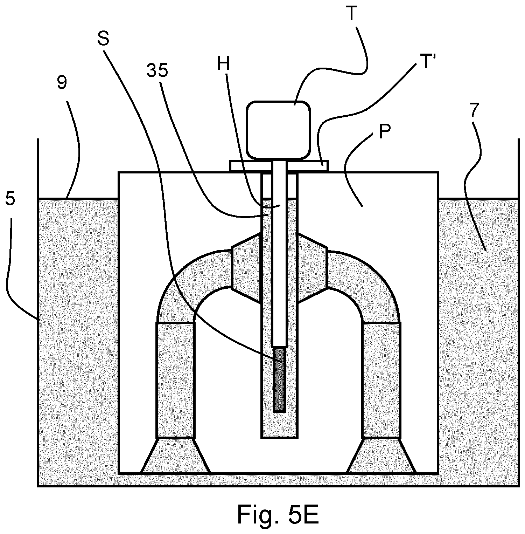

An example of this second mode is shown in Fig. 5D and 5E.

To allow the plunging mode to the device 1 of Fig. 5A-5C, the body P is brought into a fully submerged condition as shown in Fig. 5D, with the transfer mechanism T and the holder provided at a distance thereof. The body P is submerged in the reservoir 5 for receiving a volume of cryogenic fluid 7, so that the intervening gap 35 and the internal reservoir 36 is filled with cryogenic fluid. The holder H, with the sample carrier S attached to it, is positioned at a distance from the larger reservoir 5. In this idle position, as shown in Fig. 5D, the holder H is located at a distance from said plunging reservoir 5 (and said internal reservoir 36 as well). This ensures that the sample is at distance from the liquid ethane, so that it cannot be cooled.

As indicated in Fig. 5E, the transfer mechanism T has functioned as a plunging device by moving the holder H with the sample carrier S into the liquid ethane 7, so that the sample carrier S is positioned below a surface level 9 of the cryogenic coolant 7. In the plunging position the sample carrier S is inside said internal volume 36 of said plunging reservoir 5. Movement from the idle position (Fig. 5D) to the plunging position (Fig. 5E) may be done at an appropriate speed for plunge freezing of the sample.

Thus, the body P allows both a jetting mode and a plunging mode.

It is noted that in Fig. 5D and 5E, the plunging reservoir is formed by intervening gap 35 extending into the internal plunging reservoir 36. The plunging reservoir 36 comprises a cryogen inlet and a cryogen outlet, formed by the conduits 31 in the body P. The larger reservoir 5 with the liquid ethane 7 in it, forms a cryogenic fluid supply unit. By pressing the body P into the reservoir 5, the plunging reservoir 36 is filled with cryogenic fluid 7 in said plunging mode. By moving the body P upwards, most cryogenic fluid is removed from said plunging reservoir 36 through said cryogen outlet (conduits 31) in said jetting mode.

Note that by using the body P, the plunging reservoir is empty in said jetting mode, but the reservoir 36 can be filled with cryogenic fluid once jetting of the sample carrier is complete. This allows jetting and subsequently plunging of the sample, thus maintaining the sample at cryogenic temperatures.

The body P as shown in Fig. 5A-5E thus acts as a piston that is fluidly connected to said cryogenic supply unit (reservoir 5), said piston P having an internal volume (intervening gap 35 extending into internal plunging reservoir 36) that defines said plunging reservoir 36 for holding said cryogenic fluid. Further, the piston P comprises a sample carrier bore (intervening gap 35) that opens into said inner volume defining said plunging reservoir 36. And said piston P comprises at least one jetting bore (conduits 31) that opens into said inner volume defining said plunging reservoir 36, wherein said jetting bore is fluidly connected to said cryogenic supply unit 5 so that a cryogenic jet can be formed out of said at least one jetting bore.

From Fig. 5A-5E it is clear that the piston P is movably provided within said cryogenic supply unit 5, and is movable from at least a top position (Fig. 5A) to a bottom position (Fig. 5D and 5E). In said plunging mode the piston is moved to said bottom position so that said plunging reservoir 36 is filled with cryogenic fluid, and in said jetting mode the piston is moved to said top position so that said plunging reservoir 36 is substantially free from cryogenic fluid.

As indicated in Fig. 5A-5C, the piston P is moved from said top position to said bottom position whilst said jetting bore 31 is providing said jet of cryogenic fluid to said sample carrier S, so that the plunging reservoir 36 is filled with cryogenic fluid during said jetting.

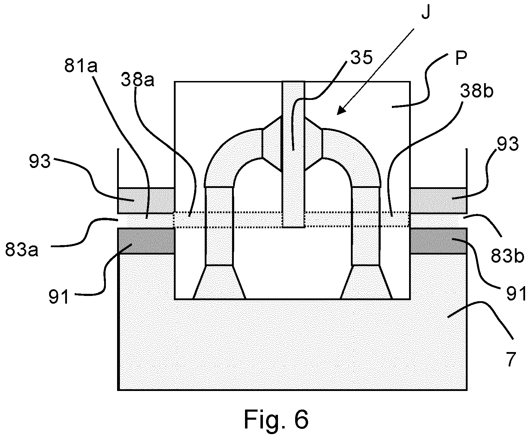

As schematically shown in Fig. 6, a seal element 91 may be provided at the surface level 9 of the cryogen bath. The seal element can be connected to the plunger P, and movable therewith. This way, the bath of cryogenic fluid with the plunger can form a closed piston. The seal 91 can be provided in the form of one Teflon-O ring, for example. This O-ring (tight at LN2 temperature) prevents spraying and splashes. The O-ring also can ensure a more controlled ethane flow from the nozzles, wherein this flow is only determined by the ratio plug diameter / nozzle opening time and the plug downwards velocity.

As is also shown in Fig. 6, a further seal element 93 can be provided. This further seal element 93 is provided above said first seal element 91. The further seal element 93 can be connected to and movable with the piston P. This seal element 93 can be an O-ring as well, wherein this further O-ring allows release of liquid ethane after the downwards action of the plunger P, in particular when resetting the plug back to the upward position, but prevent ethane leaks away while pushing downwards. In the embodiment shown, the plunger comprises a couple of further channels 38a, 38b (wherein these channels are separate from the two conduits) that are connected to the channel formed by the intervening gap 35 and the plunging reservoir 36. The bath of cryogenic fluid is provided with one or more exhaust outlets 83a. Since the at least two seal elements 91, 93 are movably connected with the plunger P, and a vertical distance is present between the two seals 91, 93, there will be a relative position between the plunger P and the cryogenic bath wherein the seal elements 91, 93 determine a flow channel 81a, 81b that connects the further channels 38a, 38b to the respective exhaust outlets 83a, 83b. This is beneficial, for example, when the plunger P is filled with cryogenic fluid and the plunger is moved upwards. Cryogenic fluid present in the intervening gap 35 and internal reservoir 36 may now be easily removed from the system when the plunger is in the position shown in Fig. 7. When the plunger is moved further upwards, the first seal element 91 once again closes off the exhaust outlet 83a. When the plunger is moved further downwards, the flow channel to the exhaust outlet 83a, 83b is also closed off. Thus, when body P is moved upwards, that portion of cryogenic fluid that is at or above mouthpiece 39a is removed. Most of the fluid is then removed via flow channel 38-81-83.

Not shown in Figs. 4 and 5, is that the device may comprise a control unit for controlling operations of the device 1, such as actuating movement of the transfer mechanism T, activation of the jetting device 1, filling and/or draining the reservoir 5, and the like.

## Claims

1. A device for preparing samples for use in a Cryo-Electron Microscope, comprising:
- a holder for holding a sample carrier;
- at least one jetting device that is arranged for providing a jet of cryogenic fluid to said sample carrier; and
- a transfer mechanism that is operably coupled to the holder for bringing the holder to a jetting position, wherein in the jetting position the holder is located near the at least one jetting device for receiving said jet of cryogenic fluid; and
**Characterized, in that** the device comprises a plunging reservoir for receiving a volume of cryogenic fluid, and **in that** the transfer mechanism is additionally arranged for bringing the holder to a plunging position, wherein in the plunging position the holder is positioned at least partly inside an internal volume of said plunging reservoir for bringing the sample carrier in contact with cryogenic fluid.

2. Device according to claim 1, wherein said device comprises a plunging mode and a jetting mode:
- wherein in the plunging mode the control unit is arranged for controlling said plunging mechanism to move said holder to said plunging position;
- wherein in the jetting mode the control unit is arranged for controlling said plunging mechanism to move said holder to the jetting position.

3. Device according to claim 2, wherein the device is arranged so that the plunging mode and the jetting mode are at least mutually exclusively selectable.

4. Device according to claim 1-3, wherein said plunging reservoir comprises a cryogen inlet and a cryogen outlet, and wherein said device comprises a cryogenic fluid supply unit, wherein said control unit is arranged for supplying cryogenic fluid from said cryogenic supply unit to said cryogen inlet for filling the plunging reservoir with cryogenic fluid in said plunging mode, and wherein said control unit is arranged for removing cryogenic fluid from said plunging reservoir through said cryogen outlet in said jetting mode.

5. Device according to claim 4, wherein said control unit is arranged for supplying cryogenic fluid from said cryogenic supply unit to said cryogen inlet for filling the plunging reservoir with cryogenic fluid in said jetting mode, in particular once initial jetting of the sample carrier is substantially complete.

6. Device according to claim 4 or 5, wherein said device comprises a piston that is fluidly connected to said cryogenic supply unit, said piston having an internal volume that defines said plunging reservoir for holding said cryogenic fluid, wherein said piston comprises a sample carrier bore that opens into said inner volume defining said plunging reservoir, and wherein said piston comprises at least one jetting bore that opens into said inner volume defining said plunging reservoir, wherein said jetting bore is fluidly connected to said cryogenic supply unit so that a cryogenic jet can be formed out of said at least one jetting bore.

7. Device according to claim 6, wherein said piston is movably provided within said cryogenic supply unit, wherein said piston is movable from a top position to a bottom position, wherein in said plunging mode the piston is moved to said bottom position so that said plunging reservoir is filled with cryogenic fluid, and wherein in said jetting mode the piston is moved to said top position so that said plunging reservoir is substantially free from cryogenic fluid.

8. Device according to claim 7, wherein in said jetting mode, said piston is moved from said top position to said bottom position whilst said jetting bore is providing said jet of cryogenic fluid to said sample carrier, so that the plunging reservoir is filled with cryogenic fluid during said jetting.

9. Device according to claim 8, wherein said holder is arranged for moving said piston from said top position to said bottom position in said jetting mode.

10. Device according to claim 1-9, wherein the holder comprises a tweezer.

11. Device according to claim 2-10, when dependent on claim 2, wherein said device comprises a user input device that is arranged for a user to select the plunging mode or the jetting mode.

12. Device according to claim 11, wherein the user input device is arranged for a user to select the plunging mode and the jetting mode mutually exclusively.

13. Device according to claim 11 or 12, wherein the control unit is connected to said user input device and is arranged for operating the device to perform the plunging mode or the jetting mode based on the input provided by the user input device.

14. Device according to claim 1-13, further comprising one or more of:
- an applicator for applying a liquid containing a specimen to a sample carrier provided in said sample holder;
- a device for removing excess liquid from a sample carrier provided in said sample holder.
